## Europäisches Patentamt

## European Patent Office

## Office européen des brevets

(19)

(11) Veröffentlichungsnummer : **0 292 546 B1**

# (12) EUROPÄISCHE PATENTSCHRIFT

(45) Veröffentlichungstag der Patentschrift :
02.05.91 Patentblatt 91/18

(51) Int. Cl.⁵ : **H01Q 1/12, H03J 3/12,**
**G01S 3/40**

(21) Anmeldenummer : 88900218.4

(22) Anmeldetag : 28.11.87

(86) Internationale Anmeldenummer :
PCT/EP87/00740

(87) Internationale Veröffentlichungsnummer :
WO 88/04478 16.06.88 Gazette 88/13

(54) Schaltungsanordnung zur Bestimmung eines Extremwertes einer Spannung.

(30) Priorität : 03.12.86 DE 3641310

(43) Veröffentlichungstag der Anmeldung :
30.11.88 Patentblatt 88/48

(45) Bekanntmachung des Hinweises auf die
Patenterteilung :
02.05.91 Patentblatt 91/18

(84) Benannte Vertragsstaaten :
AT BE CH DE FR GB IT LI LU NL SE

(56) Entgegenhaltungen :
EP-A- 0 092 600
DE-A- 2 639 529
GB-A- 2 066 469
US-A- 4 182 990

(56) Entgegenhaltungen :
Electron, booklet 31, No: 7, July 1976, (Rotterdam, NL), "Reflecties door PAoSE", page 399
Elektor, vol. 2, No: 10, October 1976, (Canterbury) GB), "Alignment squeaker", page 1029
Patent Abstracts of Japan, vol. 9, No: 201
(E-336)(1924), 17 August 1985, & JP, A, 6065633

(73) Patentinhaber : Deutsche Thomson-Brandt
GmbH
Hermann-Schwer-Strasse 3 Postfach 1307
W-7730 Villingen-Schwenningen (DE)

(72) Erfinder : MAIER, Gerhard
Reutestrasse 19
W-7735 Dauchingen (DE)
Erfinder : ARMBRUSTER, Veit
Engeleweg 4
W-7742 St. Georgen 4 (DE)

## Beschreibung

Die Erfindung betrifft eine Schaltungsanordnung zur Bestimmung eines Extremwertes einer Spannung.

Es gibt eine Vielzahl von Fällen, in denen der Extremwert einer Spannung bestimmt werden soll. So ist z.B. die Feststellung einer maximalen Ausgangsspannung eines Empfangsgerätes wichtig, entweder zur korrekten Abstimmung dieses Empfangsgerätes oder zur korrekten Ausrichtung einer Empfangsantenne. Es ist zur perfekten Einstellung des Parabolspiegels eines Satellitenempfängers ein Meßempfänger bekannt (Funkschau 1968, Heft 22, Seite 59). Ein solcher Meßempfänger ist aber in seinem Aufbau sehr aufwendig und daher kostspielig. Auch die Bedienung eines solchen Meßempfängers ist nur von einem Fachmann durchführbar und die Ablesung der optimalen Einstellung auf einer Skala nicht immer leicht erkennbar. Es ist auch bekannt, die optimale Ausrichtung einer Antenne durch eine Fernsteuerung vorzunehmen, wobei das Ergebnis über den Fernsehbildschirm feststellbar ist. Hierzu ist aber ein Fernsehgerät als Anzeigeinstrument notwendig. Auch diese Lösung ist teuer.

Zur Erleichterung der Ausrichtung einer Empfangsantenne ist es bereits bekannt, in Abhängigkeit von der Ausrichtung der Antenne, d.h. in Abhängigkeit von der Antennenspannung mit Hilfe eines Spannungs-Frequenzwandlers diese in eine hörbare Tonfrequenz umzuwandeln, wodurch an der zur Antennenspannung proportionalen Tonhöhe die Ausrichtung erkannt werden kann, ohne durch ein optisches Meßinstrument abgelenkt zu werden. (DE-A-26 39 529). Hierbei ergeben sich aber noch Schwierigkeiten dadurch, daß ein Tonhöhenmaximum oder Minimum oft nicht leicht hörbar sind, wenn z.B. der Ausrichter kein so empfindliches Ohr besitzt oder wenn die Tonhöhenänderungen sehr klein sind, d.h., wenn der Extremwert der Tonhöhenänderung sehr flach verläuft.

Der Erfindung liegt die Aufgabe zugrunde, die Ausrichtung einer Antenne dahingehend weiter zu vereinfachen, daß die Erkennung des Extremwertes der Ausgangsspannung der Antenne noch leichter zu erkennen ist. Diese Aufgabe wird durch die im Patentanspruch angegebene Maßnahme gelöst.

Die Bestimmung der optimalen Ausrichtung einer Antenne 1 ergibt sich aus der Messung der gleichgerichteten ZF-Ausgangsspannung $U_A$ des Antennenverstärkers 2. Diese Ausgangsspannung $U_A$ wird auf einen Spannungs-Frequenz-Wandler 3 gegeben, der die Eigenschaft hat, bei einer hohen Eingangsspannung eine niedrige Frequenz abzugeben und umgekehrt. Die Frequenz des Ausgangssignals des Spannungs-Frequenz-Wandlers 3 ist um so höher, je kleiner die Eingangsspannung $U_A$ ist, d.h. bei einer schlechten Ausrichtung der Antenne 1. Die Ausgangsspannung $U_B$ des Spannung-Frequenz-Wandlers 3 besteht aus Impulsen I, die mittelbar über einen elektroakustischen Wandler 6 in ein akustisches Signal umgewandelt werden. Die Impulse I betätigen über einen Steuereingang C einen elektronischen Schalter 4. Der Schalter 4 wird während der Impulse I geschlossen und schaltet ein von einem Oszillator 5 im Hörbereich von z.B. 1000 Hz erzeugtes Signal durch, welches dem Eingang A des elektronischen Schalters 4 zugeführt wird, an dessen Ausgang B Impulspakete I' abnehmbar sind, die nach Verstärkung in einem NF-Verstärker 7 über den elektroakustischen Wandler 6 hörbar gemacht werden. Beim Ausrichten der Antenne 1 wird die Antennenspannung zunächst sehr klein sein, so daß die 1000-Hz-Impulspakete I' sehr schnell aufeinanderfolgen. Bei Annäherung an die optimale Ausrichtung werden die Impulspakete I' in immer größeren zeitlichen Abständen hörbar und je nach Auslegung des Spannung-Frequenz-Wandlers gar nicht mehr auftreten. Dieses bringt den Vorteil, daß auch ein nicht geübter Fachmann oder sogar ein Laie die Einstellung der Antenne vornehmen kann, weil das akustische Signal eindeutig und leicht ausgewertet werden kann.

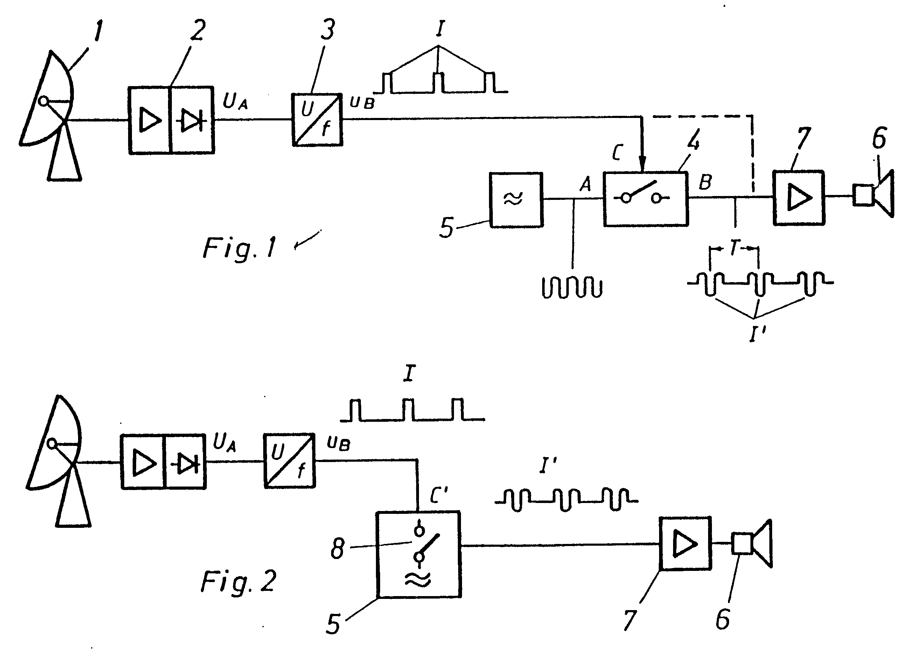

In Figur 2 ist eine weitere Schaltungsvariante der Erfindung dargestellt. Während in Figur 1 die Signalspannung des Oszillators 5 über den gesteuerten Schalter 4 im Rhythmus der Impulse I durchgeschaltet wird, können die Impulspakete I' derart erzeugt werden, daß der Oszillator 5 selbst über den Steuereingang C' und einen Schalter 8 im Rhythmus der Impulse I eingeschaltet wird.

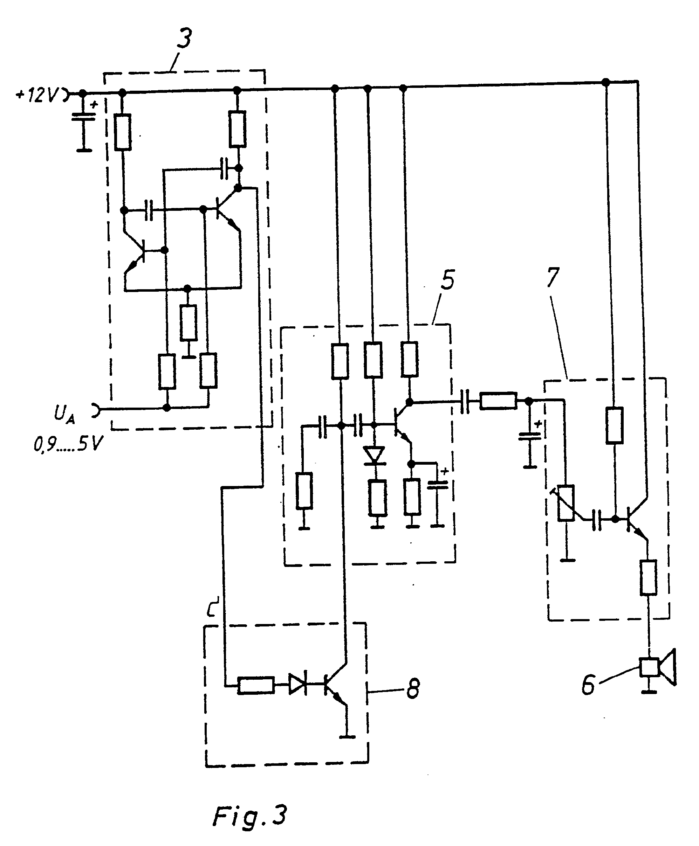

In Figur 3 ist ein detailliertes Schaltbild gemäß der Schaltung nach Figur 2 wiedergegeben.

## Ansprüche

1. Schaltungsanordnung zur Bestimmung eines Extremwertes einer Spannung (UA), die mit Hilfe eines Spannungs-Frequenz-Wandlers in ein akustisches Signal umgewandelt wird, dessen Frequenz von der Spannung abhängt, **dadurch gekennzeichnet, daß** die Spannung (UA) mit Hilfe des Spannungs-Frequenz-Wandlers (3) in ein Schaltsignal (I) umgewandelt wird, welches das Ausgangssignal eines mit konstanter, im Hörbereich liegender Frequenz schwingenden Oszillators (5) an den Eingang einer akustischen Wiedergabeanordnung (6, 7) schaltet, wobei Impulspakete I' des Oszillators (5) erzeugt werden, die im Rhythmus des Ausgangssignals (I) des Spannungs-Frequenz-Wandlers (3) auftreten, wobei die Frequenz des Schaltsignals (I) zur Spannung (UA) umgekehrt proportional ist.

2. Schaltungsanordnung nach Anspruch 1, **dadurch gekennzeichnet, daß** das Schaltsignal (I) an den Steuereingang (C) einer Schaltstufe (4) gelegt ist, und daß an den Eingang (A) der Schaltstufe (4) das Ausgangssignal des Oszillators (5) mit konstanter, im Hörbereich liegender Frequenz geschaltet ist, und daß am Ausgang (B) der Schaltstufe (4) Impulspakete (I') des Oszillatorsignals im Rhythmus des Ausgangssignals (I) des Spannungs-Frequenz-Wandlers (3) abnehmbar sind.

3. Schaltungsanordnung nach Anspruch 1, **dadurch gekennzeichnet**, daß das Schaltsignal (I) an den Steuereingang (C') eines Oszillators (5) gelegt ist, der über einen Schalter (8) den Oszillator (5) im Rhythmus des Schaltsignals (I) einschaltet.

## Claims

1. A circuit arrangement for determining an extreme value of a voltage (UA) which, with the aid of a voltage/frequency converter, is converted into an acoustic signal, the frequency of which depends on the voltage, **characterised in that** the voltage (UA) is converted with the aid of the voltage/frequency converter (3) into a switching signal (I) which switches the output signal of an oscillator (5), resonating at constant frequency in the audible range, to the input of an acoustic reproduction arrangement (6, 7), in which pulse packets I' of the oscillator (5) are produced which appear in synchronism with the output signal (I) of the voltage/frequency converter (3), the frequency of the switching signal (I) being inversely proportional to the voltage (UA).

2. A circuit arrangement according to claim 1, **characterised in that** the switching signal (I) is applied to the control input (C) of a switching stage (4), and that to the input (A) of the switching stage (4) there is connected the output signal of the oscillator (5) at constant frequency in the audible range, and that pulse packets (I') of the oscillator signal may be tapped at the output (B) of the switching stage (4) in synchronism with the output signal (I) of the voltage/frequency converter (3).

3. A circuit arrangement according to claim 1, **characterised in that** the switching signal (I) is applied to the control input (C') of an oscillator (5), which switches on the oscillator (5) via a switch (8) in synchronism with the switching signal (I) .

## Revendications

1. Montage servant à déterminer une valeur extrême d'une tension (UA) qui est convertie en un signal acoustique à l'aide d'un convertisseur tension-fréquence dont la fréquence dépend de la tension, caractérisé en ce que la tension (UA) est convertie en un signal de commutation (I) à l'aide d'un convertisseur tension-fréquence (3) qui applique le signal de sortie d'un oscillateur (5) entretenant des oscillations constantes dans la gamme de fréquences audibles à l'entrée d'un circuit acoustique de reproduction (6, 7), des paquets d'impulsions (I') du signal d'oscillateur (5) étant générées et apparaissant au rythme du signal de sortie (I) du convertisseur tension-fréquence (3), alors que la fréquence du signal de commutation (I) est inversement proportionnelle à la tension (UA).

2. Montage selon la revendication 1, caractérisé en ce que le signal de commutation (I) est appliqué à l'entrée de commande (C) d'un étage de commutation (4) et que le signal de sortie de l'oscillateur (5) entretenant des oscillations constantes dans la gamme de fréquences audibles, est appliqué à l'entrée (A) de l'étage de commutation (4) et que la sortie (B) de l'étage de commutation (4) délivre des paquets d'impulsions (I') du signal d'oscillateur au rythme du signal de sortie (I) du convertisseur tension-fréquence (3).

3. Montage selon la revendication 1, caractérisé en ce que le signal de commutation (I) est appliqué a l'entrée de commande (C') d'un oscillateur (5) qui connecte l'oscillateur (5) par un commutateur (8) au rythme du signal de commutation (I).

Fig.1

Fig.2

EP 0 292 546 B1

Fig.3